# EUROPEAN PATENT APPLICATION

(11) **EP 4 852 327 A1**
(43) Date of publication of application: **09.12.2026**
(21) Application number: 26182487.4
(22) Date of filing: 02.06.2026
(51) Int. Cl.: H03M 7/40, H03M 7/30

(54) **DATA COMPRESSION AND DATA DECOMPRESSION CIRCUITS**

(30) Priority: 06.06.2025 IN 202541054682
(71) Applicant: NXP B.V., 5656 AG Eindhoven (NL)
(72) Inventor: Kuderu Siddarajappa, Dayananda, 5656AG Eindhoven (NL); BRETT, Maik, 5656AG Eindhoven (NL); Balasubramanian, Desingh Devibalan, 5656AG Eindhoven (NL); S., Harikrishnan, 5656AG Eindhoven (NL)
(74) Representative: Schwarzweller, Thomas

(57) **Abstract**

Data compression and data decompression circuits are disclosed. The data compression circuit receives digital data and performs a first compression on the digital data based on differential pulse code modulation (DPCM) encoding to generate differential encoded data. Further, the data compression circuit performs a second compression on the differential encoded data based on exponential Golomb encoding to generate exponential Golomb encoded compressed data that is a compressed version of the digital data. The data decompression circuit receives the compressed data and performs a first decompression on the compressed data based on exponential Golomb decoding to generate back the differential encoded data. Further, the data decompression circuit performs a second decompression on the differential encoded data based on DPCM decoding to generate back the digital data. The compression and decompression operations are lossless operations. As a result, no data is lost during the compression and decompression operations.

## Description

### FIELD OF USE

The present disclosure relates generally to electronic circuits, and, more particularly, to data compression and data decompression circuits.

### BACKGROUND

Modern digital systems and communication networks are required to store, transmit, and process large volumes of data quickly and with minimal delay. The rapid increase in data volume creates major challenges for bandwidth, storage, and transmission efficiency. These challenges may strain existing infrastructure and affect overall system performance. Traditional methods of storing and communicating data often fall short of addressing these demands in environments with limited resources.

### BRIEF DESCRIPTION OF THE DRAWINGS

The following detailed description of the embodiments of the present disclosure will be better understood when read in conjunction with the appended drawings. The present disclosure is illustrated by way of example, and not limited by the accompanying figures, in which like references indicate similar elements.
FIG. 1 illustrates a system that facilitates data compression and data decompression in accordance with an embodiment of the present disclosure;
FIG. 2 illustrates a data compression circuit and a data decompression circuit of the system of FIG. 1 in accordance with an embodiment of the present disclosure;
FIG. 3 illustrates a data compression circuit in accordance with another embodiment of the present disclosure; and
FIG. 4 represents a flowchart that illustrates a data compression method in accordance with an embodiment of the present disclosure.

### DETAILED DESCRIPTION

The detailed description of the appended drawings is intended as a description of the embodiments of the present disclosure, and is not intended to represent the only form in which the present disclosure may be practiced. It is to be understood that the same or equivalent functions may be accomplished by different embodiments that are intended to be encompassed within the scope of the present disclosure.

### Overview:

Modern data processing systems are increasingly required to handle large, multi-dimensional datasets to support high-resolution analysis and enhanced system performance. As technological capabilities evolve to meet more complex functional and operational demands, the volume and rate of data generation continue to grow rapidly. This growth places significant challenges for data transport and storage infrastructure, leading to increased requirements for interface bandwidth and storage capacity. A key challenge lies in efficiently transferring high-volume raw data from data acquisition components to centralized processing units or storage systems.

Advanced Radio Detection and Ranging (RADAR) systems, such as those used in imaging RADAR for automotive applications (e.g., Advanced Driver Assistance Systems (ADAS)), may require processing of large RADAR data (e.g., RADAR analog-to-digital converter (ADC) data) to achieve high resolution and improved performance. As imaging RADAR capabilities evolve to meet increasingly complex functional and safety requirements, the volume and rate of RADAR data continue to grow substantially. This growth results in larger RADAR data and higher data throughput demands. A significant challenge arises in transporting the high-volume raw RADAR data from a RADAR front-end circuit to centralized processing units or data recorders. Thus, existing system architectures may require a large interface bandwidth to support the transmission of the RADAR data. Additionally, higher storage capacity may be required for recording RADAR data in use cases such as million-mile drive testing.

Thus, there is a need for a solution to facilitate the handling of high-volume raw RADAR data. Various embodiments of the present disclosure disclose an electronic circuit that may include a data compression circuit. The data compression circuit may receive digital data (for example, the raw RADAR data). The data compression circuit may further perform first compression on the digital data based on differential pulse code modulation (DPCM) encoding to generate differential encoded data. The differential encoded data may correspond to a first compressed version of the digital data. Further, the data compression circuit may perform a second compression on the differential encoded data based on exponential Golomb encoding to generate exponential Golomb encoded compressed data. The exponential Golomb encoded compressed data may correspond to a second compressed version of the digital data.

The performance of the first compression based on the DPCM encoding may result in reducing the standard deviation of the digital data. Additionally, due to the first compression, a data rate of the differential encoded data may be lesser than a data rate of the digital data. Further, the performance of the second compression on the differential encoded data results in the exploitation of sparsity in the differential encoded data. As a result, the data rate of the exponential Golomb encoded compressed data may be lesser than the data rate of the differential encoded data, thereby resulting in a high compression ratio in comparison to conventional data compression techniques. Consequently, the bandwidth requirement for transmission of the compressed data is reduced in comparison to conventional bandwidth requirements. Additionally, the storage capacity required for storing the compressed data may be lower in comparison to conventional storage requirements. In some embodiments, the performance of the first compression and the second compression may correspond to lossless compression. As a result, the digital data may be reconstructed using the exponential Golomb encoded compressed data without any data loss.

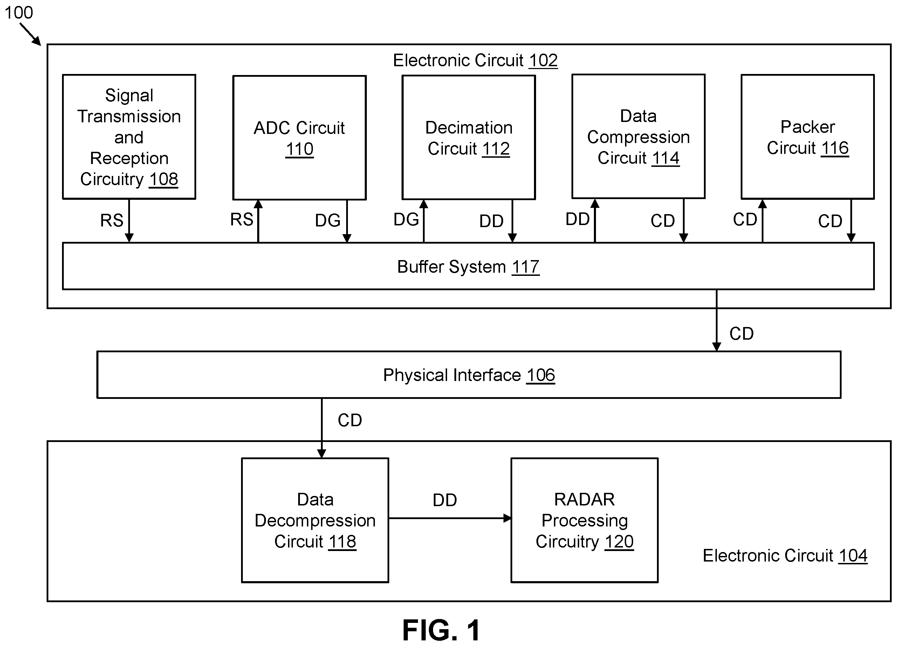

FIG. 1 illustrates a system 100 that facilitates data compression and data decompression in accordance with an embodiment of the present disclosure. The system 100 may include an electronic circuit 102 and an electronic circuit 104. The electronic circuit 102 and the electronic circuit 104 may be coupled to each other by way of a physical interface 106. For the sake of ongoing discussion, it is assumed that the system 100 is implemented for a Radio Detection and Ranging (RADAR) system. The RADAR system may be utilized for advanced driver assistance systems (ADAS), autonomous vehicles, surveillance, or the like. In the system 100, the electronic circuit 102 may correspond to a RADAR front-end circuit that may perform data acquisition, and the electronic circuit 104 may correspond to a centralized processing circuit that may process the acquired data. The acquired data may be large, multi-dimensional RADAR data, and hence, there is a need for efficient data transmission from the electronic circuit 102 to the electronic circuit 104 by way of the physical interface 106.

The scope of the present disclosure is not limited to the system 100 being implemented for a RADAR system. In several embodiments, the system 100 may be implemented for various applications such as health care, biomedical monitoring, industrial monitoring, or the like.

### Electronic circuit 102:

The electronic circuit 102 may include suitable circuitry that may be configured to perform one or more operations. For example, the electronic circuit 102 may be configured to generate and transmit RADAR signals. The electronic circuit 102 may be further configured to receive RADAR signals reflected from surrounding objects. The received RADAR signals may correspond to analog signals. Further, the electronic circuit 102 may be configured to convert the received RADAR signals to digital data.

The electronic circuit 102 may be further configured to decimate the digital data and compress the decimated digital data. The electronic circuit 102 may be configured to perform a first compression on the decimated digital data based on differential pulse code modulation (DPCM) encoding to generate differential encoded data. Further, the electronic circuit 102 may be configured to perform a second compression on the differential encoded data based on exponential Golomb encoding to generate exponential Golomb encoded compressed data. The performance of the first compression and the second compression may correspond to the compression of the decimated digital data.

The electronic circuit 102 may include signal transmission and reception circuitry 108, an analog-to-digital conversion (ADC) circuit 110, a decimation circuit 112, a data compression circuit 114, and a packer circuit 116.

### Signal transmission and reception circuitry 108:

The signal transmission and reception circuitry 108 may be coupled to the ADC circuit 110. The signal transmission and reception circuitry 108 may include suitable circuitry (e.g., one or more antennas, one or more transceivers, one or more amplifiers, one or more filters, one or more mixers, one or more oscillators, or a combination thereof) that may be configured to perform one or more operations. For example, the signal transmission and reception circuitry 108 may be configured to generate the RADAR signals. Further, the signal transmission and reception circuitry 108 may be configured to transmit the generated RADAR signals into the space surrounding the signal transmission and reception circuitry 108 (e.g., the space surrounding a device or a system including the electronic circuit 102). The signal transmission and reception circuitry 108 may be further configured to receive the RADAR signals reflected from the surrounding objects in the space. The received RADAR signals may be hereinafter referred to as the "reflected RADAR signals". The signal transmission and reception circuitry 108 may be configured to provide the reflected RADAR signals (denoted as "RS" in FIG. 1) to the ADC circuit 110.

### ADC circuit 110:

The ADC circuit 110 may be coupled to the signal transmission and reception circuitry 108 and the decimation circuit 112. The ADC circuit 110 may include suitable circuitry that may be configured to perform one or more operations. For example, the ADC circuit 110 may be configured to receive the reflected RADAR signals RS from the signal transmission and reception circuitry 108. The reflected RADAR signals RS may correspond to analog signals. An analog signal is a continuous waveform that varies smoothly over time. The ADC circuit 110 may be further configured to convert the reflected RADAR signals RS to the digital data. The conversion of an analog signal to digital data may refer to a process of sampling the analog signal at discrete time intervals into samples and quantizing each sample into a binary value. Thus, the digital data may include a plurality of quantized samples.

The sampling of the analog signal to the digital data may be associated with a sampling rate. The sampling rate may refer to a frequency at which discrete samples are acquired from a continuous-time analog signal for analog to digital conversion. The sampling rate is expressed in samples per second (SPS). In some examples, the sampling rate of the ADC circuit 110 may correspond to the Nyquist rate or greater than the Nyquist rate. Based on the sampling rate of the ADC circuit 110 and a bit resolution of each sample in the digital data, a data rate may be determined. The data rate may refer to the amount of digital data transmitted, processed, or stored per unit of time, typically expressed in bits per second (bps). In an example, the sampling rate of the ADC circuit 110 may be 40 million SPS (MSPS) with 12 bits per sample as the bit resolution. In such an example, the data rate of the ADC circuit 110 may be 480 Mega bps (Mbps). The ADC circuit 110 may be further configured to provide the digital data (denoted as "DG" in FIG. 1) to the decimation circuit 112.

### Decimation circuit 112:

The decimation circuit 112 may be coupled to the ADC circuit 110 and the data compression circuit 114. The decimation circuit 112 may include suitable circuitry (e.g., one or more data interfaces, one or more processors, one or more logic circuits, one or more data storage structures, or a combination thereof) that may be configured to perform one or more operations. For example, the decimation circuit 112 may be configured to receive the digital data DG from the ADC circuit 110. Further, the decimation circuit 112 may be configured to decimate the digital data DG. The decimation circuit 112 may be further configured to output the decimated digital data (denoted as "DD" in FIG. 1) based on the decimation of the digital data DG. Decimation may refer to a process of reducing the sampling rate of the digital data DG by retaining a subset of the plurality of quantized samples after low-pass filtering of the digital data DG to prevent aliasing. The decimation circuit 112 may retain the subset of the plurality of quantized samples such that a sampling rate of the subset of the plurality of quantized samples may correspond to the Nyquist rate or greater than the Nyquist rate. The decimation may be associated with a decimation factor. In reference to the above-described example, the decimation factor may be 8 which refers to retaining 1 out of 8 samples after the low-pass filtering. Thus, the sampling rate and the data rate of the decimated digital data DD may be 5 MSPS and 60 Mbps, respectively. The subset of the plurality of the quantized samples retained based on the decimation may be hereinafter referred to as the "plurality of ADC samples". In other words, the decimated digital data DD may correspond to the plurality of ADC samples.

### Data compression circuit 114:

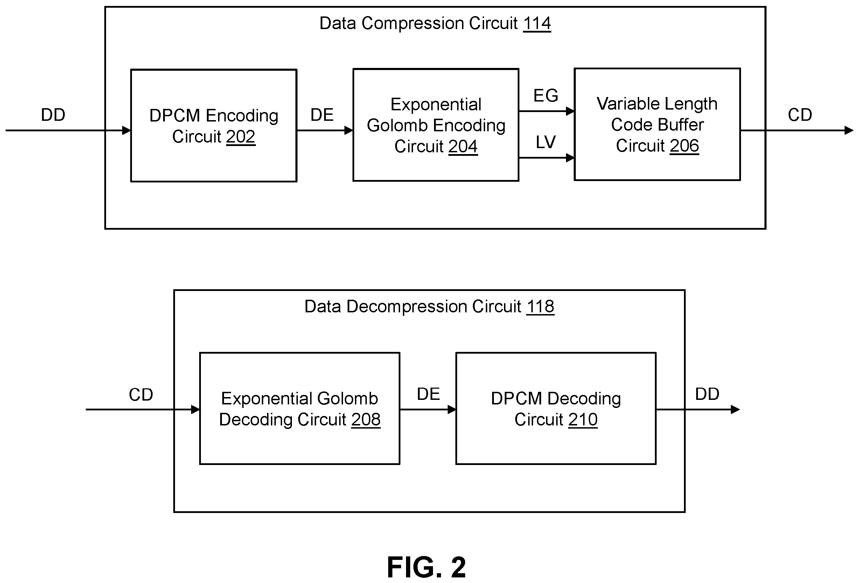

The data compression circuit 114 may be coupled to the decimation circuit 112 and the packer circuit 116. The data compression circuit 114 may include suitable circuitry (e.g., one or more data interfaces, one or more processors, one or more logic circuits, one or more data storage structures, or a combination thereof) that may be configured to perform one or more operations. For example, the data compression circuit 114 may be configured to receive the decimated digital data DD. The data compression circuit 114 may be further configured to perform the first compression on the decimated digital data DD based on the DPCM encoding to generate the differential encoded data. The differential encoded data may correspond to a representation of the plurality of ADC samples, where each ADC sample is encoded as a difference between a corresponding ADC sample and a predicted ADC sample. The predicted ADC sample may be processed based on one or more prior ADC samples of the plurality of ADC samples. The performance of the first compression on the decimated digital data DD based on the DPCM encoding to generate the differential encoded data is further explained in detail in conjunction with FIG. 2.

The data compression circuit 114 may be further configured to perform the second compression on the differential encoded data based on the exponential Golomb encoding to generate the exponential Golomb encoded compressed data. The exponential Golomb encoded compressed data may correspond to a representation of the differential encoded data as a variable-length bitstring composed of a unary prefix and a binary suffix. The performance of the second compression on the differential encoded data based on the exponential Golomb encoding to generate the exponential Golomb encoded compressed data is further explained in detail in conjunction with FIG. 2.

The data compression circuit 114 may be further configured to aggregate the exponential Golomb encoded compressed data based on an aggregation value and a plurality of length values associated with the exponential Golomb encoded compressed data. The exponential Golomb encoded compressed data may correspond to a compressed version of the decimated digital data DD. Thus, a data rate of the exponential Golomb encoded compressed data may be significantly lower than the data rate of the decimated digital data DD. The data compression circuit 114 may be further configured to output aggregated exponential Golomb encoded compressed data based on the aggregation. The aggregation of the exponential Golomb encoded compressed data is further described in detail in conjunction with FIG. 2. The aggregated exponential Golomb encoded compressed data may be alternatively referred to as the "compressed data" (denoted as "CD" in FIG. 1). In some examples, the data compression circuit 114 may be implemented as a hardware accelerator in the electronic circuit 102. Thus, the processing latency of the data compression circuit 114 may be low.

### Packer circuit 116:

The packer circuit 116 may be coupled to the data compression circuit 114. The packer circuit 116 may include suitable circuitry (e.g., one or more data interfaces, one or more processors, one or more logic circuits, one or more data storage structures, or a combination thereof) that may be configured to perform one or more operations. For example, the packer circuit 116 may be configured to format the compressed data CD based on compliance requirements of the physical interface 106. In an example, the formatting of the compressed data CD may correspond to the insertion of at least one of the time stamps, frame headers, or status flags into the compressed data CD. The packer circuit 116 may be further configured to transmit the compressed data CD to the physical interface 106 after the formatting. In other words, the electronic circuit 102 may be further configured to transmit the compressed data CD to the physical interface 106.

In some embodiments, the electronic circuit 102 may further include a buffer system 117. The buffer system 117 may be coupled to the signal transmission and reception circuitry 108, the ADC circuit 110, the decimation circuit 112, the data compression circuit 114, and the packer circuit 116. The buffer system 117 may include suitable circuitry that may be configured to perform one or more operations. For example, the buffer system 117 may be configured to facilitate the signal transmission and reception circuitry 108 to provide the reflected RADAR signals RS to the ADC circuit 110. In other words, the signal transmission and reception circuitry 108 may provide the reflected RADAR signals RS to the ADC circuit 110 via the buffer system 117. The buffer system 117 may include a plurality of buffer circuits. To provide the reflected RADAR signals RS to the ADC circuit 110, the signal transmission and reception circuitry 108 may store the reflected RADAR signals RS in a first buffer circuit of the plurality of buffer circuits. Further, the ADC circuit 110 may retrieve the reflected RADAR signals RS from the first buffer circuit.

The ADC circuit 110 may provide the digital data DG to the decimation circuit 112 via the buffer system 117. To provide the digital data DG to the decimation circuit 112, the ADC circuit 110 may store the digital data DG in a second buffer circuit of the plurality of buffer circuits. Further, the decimation circuit 112 may retrieve the digital data DG from the second buffer circuit.

The decimation circuit 112 may provide the decimated digital data DD to the data compression circuit 114 via the buffer system 117. To provide the decimated digital data DD, the decimation circuit 112 may store the decimated digital data DD in a third buffer circuit of the plurality of buffer circuits. Further, the data compression circuit 114 may retrieve the decimated digital data DD from the third buffer circuit.

The data compression circuit 114 may provide the compressed data CD to the packer circuit 116 via the buffer system 117. To provide the compressed data CD, the data compression circuit 114 may store the compressed data CD in a fourth buffer circuit of the plurality of buffer circuits. Further, the packer circuit 116 may retrieve the compressed data CD from the fourth buffer circuit. Furthermore, the packer circuit 116 may transmit the compressed data CD to the physical interface 106 after the formatting via the buffer system 117.

Although the electronic circuit 102 is shown to include the buffer system 117, the scope of the present disclosure is not limited to it. In various embodiments, the electronic circuit 102 may be independent of the buffer system 117, without deviating from the scope of the present disclosure. In such cases, data may be communicated directly between various components of the electronic circuit 102.

### Physical Interface 106:

The physical interface 106 may include suitable circuitry that may be configured to perform one or more operations. For example, the physical interface 106 may be configured to receive the compressed data CD from the electronic circuit 102. The physical interface 106 may be further configured to transmit the compressed data CD to the electronic circuit 104. In some embodiments, prior to the transmission of the compressed data CD, the physical interface 106 may be further configured to perform a set of operations on the compressed data CD.

The set of operations may include at least one of framing and packetization of the compressed data CD, insertion of the protocol control word, error detection code generation, serialization, or the like. In an example, the framing and packetization of the compressed data CD may refer to the conversion of the compressed data CD into frames or packets based on a protocol associated with the physical interface 106. Additionally, packet headers, a start-of-frame indicator, and an end-of-frame indicator may be added to the frames or packets. Upon the framing and packetization, control symbols or protocol-specific markers may be inserted for facilitating synchronization, addressing, or identification. Further, error checking codes such as CRC (Cyclic Redundancy Check) or ECC (Error Correction Code) may be appended to facilitate verification of data integrity. Furthermore, the compressed data CD may be converted from a parallel format to a serial format.

Examples of the physical interface 106 may include Ethernet, camera serial interface (CSI), serial peripheral interface (SPI), low-voltage differential signaling (LVDS), Peripheral Component Interconnect Express (PCIE), or the like.

The data compression circuit 114 performs the first compression based on the DPCM encoding that may result in reducing the standard deviation of the decimated digital data DD. Additionally, the data rate of the differential encoded data may be lesser than the data rate of the decimated digital data DD due to the first compression. Further, the data compression circuit 114 performs the second compression on the differential encoded data based on the exponential Golomb encoding that may result in the exploitation of sparsity in the differential encoded data. As a result, the data rate of the exponential Golomb encoded compressed data may be lesser than the data rate of the differential encoded data, thereby resulting in a higher compression ratio in comparison to conventional data compression techniques. Consequently, the bandwidth requirement of the physical interface 106 for transmission of the compressed data CD is reduced in comparison to conventional bandwidth requirements. Also, the storage capacity required for storing the compressed data CD may be lower in comparison to conventional storage requirements. Additionally, the performance of the first compression and the second compression may correspond to lossless compression. As a result, no data is lost during the first compression and the second compression.

Thus, the DPCM technique results in data being predictable, and the Golomb encoding capitalizes on this structure to compress it effectively. Hence, when used in sequence, the combination yields a compact representation with low computational complexity. Thus, by performing the first and second compressions, the digital data DG is compressed into a form that may result in efficient and accurate transmission over the physical interface 106.

### Electronic circuit 104:

The electronic circuit 104 may include suitable circuitry that may be configured to perform one or more operations. For example, the electronic circuit 104 may be configured to receive the compressed data CD from the physical interface 106. The electronic circuit 104 may be further configured to perform a first decompression on the compressed data CD based on exponential Golomb decoding to generate the differential encoded data. The electronic circuit 104 may be further configured to perform a second decompression on the differential encoded data based on DPCM decoding to generate the decimated digital data DD. The electronic circuit 104 may be further configured to perform a set of RADAR operations on the decimated digital data DD. The electronic circuit 104 may include a data decompression circuit 118 and RADAR processing circuitry 120.

### Data decompression circuit 118:

The data decompression circuit 118 may be coupled to the RADAR processing circuitry 120. The data decompression circuit 118 may include suitable circuitry (e.g., one or more data interfaces, one or more processors, one or more logic circuits, one or more data storage structures, or a combination thereof) that may be configured to perform one or more operations. For example, the data decompression circuit 118 may be configured to receive the compressed data CD from the physical interface 106. Further, the data decompression circuit 118 may be configured to perform the first decompression on the compressed data CD based on the exponential Golomb decoding to generate the differential encoded data. Thus, the differential encoded data is restored from the compressed data CD. Furthermore, the data decompression circuit 118 may be configured to perform the second decompression on the differential encoded data based on the DPCM decoding to generate the decimated digital data DD. Thus, the decimated digital data DD is restored from the differential encoded data. Additionally, the first decompression and the second decompression collectively result in lossless decompression. In other words, the decimated digital data may be restored exactly as it was prior to the compression. The data decompression circuit 118 may be further configured to provide the decimated digital data DD to the RADAR processing circuitry 120.

### RADAR processing circuitry 120

The RADAR processing circuitry 120 may be coupled to the data decompression circuit 118. The RADAR processing circuitry 120 may include suitable circuitry (e.g., one or more data interfaces, one or more processors, one or more logic circuits, one or more data storage structures, or a combination thereof) that may be configured to perform one or more operations. For example, the RADAR processing circuitry 120 may be configured to receive the decimated digital data DD and perform the set of RADAR operations on the decimated digital data DD. The set of RADAR operations may include at least one of Range Fast Fourier Transform (RFFT), Doppler FFT (DFFT), peak detection, angle-of-arrival estimation, or the like. The RADAR processing circuitry 120 may be further configured to obtain range profiles associated with the surrounding objects based on the Range FFT. Additionally, the RADAR processing circuitry 120 may be configured to obtain velocity profiles associated with the surrounding objects based on the Doppler FFT. Furthermore, the RADAR processing circuitry 120 may be configured to obtain the angle-of-arrival of the surrounding objects based on the angle-of-arrival estimation.

Although not shown, in various embodiments, the electronic circuit 104 may include a buffer circuit via which the data decompression circuit 118 may provide the decimated digital data DD to the RADAR processing circuitry 120.

It will be apparent to a person skilled in the art that the electronic circuit 102 and the electronic circuit 104 may include additional components to facilitate various operations of the RADAR system.

FIG. 2 illustrates the data compression circuit 114 and the data decompression circuit 118 in accordance with an embodiment of the present disclosure.

The data compression circuit 114 may include a DPCM encoding circuit 202, an exponential Golomb encoding circuit 204, and a variable length code buffer circuit 206.

### DPCM encoding circuit 202:

The DPCM encoding circuit 202 may be coupled to the decimation circuit 112 and the exponential Golomb encoding circuit 204. The DPCM encoding circuit 202 may include suitable circuitry (e.g., one or more data interfaces, one or more processors, one or more logic circuits, one or more data storage structures, or a combination thereof) that may be configured to perform one or more operations. For example, the DPCM encoding circuit 202 may be configured to receive the decimated digital data DD. The DPCM encoding circuit 202 may be further configured to perform the first compression on the decimated digital data DD. The first compression may be performed based on the DPCM encoding. Further, the DPCM encoding circuit 202 may be configured to generate the differential encoded data (denoted as "DE" in FIG. 2) based on the first compression. As described previously, the decimated digital data DD corresponds to the plurality of ADC samples. Further, each ADC sample is encoded as a difference between the corresponding ADC sample and the predicted ADC sample.

To encode an ADC sample of the plurality of ADC samples, the DPCM encoding circuit 202 may be configured to perform a set of DPCM encoding operations. The set of DPCM encoding operations may include the prediction of an ADC sample based on the one or more prior ADC samples to obtain a predicted ADC sample for a corresponding ADC sample of the plurality of ADC samples. The set of DPCM encoding operations may further include subtraction of the predicted ADC sample from the corresponding ADC sample to obtain a difference. Further, the set of DPCM encoding operations may include encoding of the difference based on a fixed or variable-length binary code to obtain a differential encoded sample. Each ADC sample of the plurality of ADC samples may be encoded in the above-described manner to generate the differential encoded data DE. Thus, the differential encoded data DE may correspond to the representation of the plurality of ADC samples where each ADC sample is encoded as the difference between the corresponding ADC sample and the predicted ADC sample. In other words, the differential encoded data may correspond to a plurality of differential encoded samples.

In some embodiments, the DPCM encoding circuit 202 may be associated with a set of DPCM coefficients. In such embodiments, the prediction of the ADC sample may be further processed based on the set of DPCM coefficients. Each DPCM coefficient of the set of DPCM coefficients may correspond to a numerical weight applied to the one or more prior ADC samples utilized for the prediction. Additionally, the set of DPCM coefficients may be configurable.

In some examples, the DPCM encoding circuit 202 may be exclusive of multiplication blocks. As a result, area and power required for the DPCM encoding circuit 202 may be reduced. The performance of the DPCM encoding on the plurality of ADC samples may result in the reduction of the standard deviation of the plurality of ADC samples. In other words, a standard deviation associated with the differential encoded data may be lesser than a standard deviation associated with the plurality of ADC samples. The DPCM encoding circuit 202 may be further configured to output the differential encoded data DE. A data rate of the differential encoded data DE may be less than the data rate of the decimated digital data DD based on the first compression.

### Exponential Golomb encoding circuit 204:

The exponential Golomb encoding circuit 204 may be coupled to the DPCM encoding circuit 202 and the variable length code buffer circuit 206. The exponential Golomb encoding circuit 204 may include suitable circuitry (e.g., one or more data interfaces, one or more processors, one or more logic circuits, one or more data storage structures, or a combination thereof) that may be configured to perform one or more operations. For example, the exponential Golomb encoding circuit 204 may be configured to receive the differential encoded data DE from the DPCM encoding circuit 202. Further, the exponential Golomb encoding circuit 204 may be configured to perform the second compression on the differential encoded data DE. Furthermore, the exponential Golomb encoding circuit 204 may be configured to generate the exponential Golomb encoded compressed data (denoted as "EG" in FIG. 2) based on the second compression. The exponential Golomb encoded compressed data EG may include a plurality of exponential Golomb encoded compressed samples. As described above, the exponential Golomb encoded compressed data EG may correspond to a representation of the differential encoded data DE as a variable-length bitstring composed of a unary prefix and a binary suffix. The exponential Golomb encoding circuit 204 may be associated with an order value. The order value (for example, 'k') of the exponential Golomb encoding circuit 204 may be configurable. Further, the performance of the second compression may be based on the order value. The exponential Golomb encoding circuit 204 may be further configured to output the plurality of length values (denoted as "LV" in FIG. 2) associated with the exponential Golomb encoded compressed data EG. A length value may correspond to number of bits in a compressed sample.

The performance of the second compression and the generation of the exponential Golomb encoded compressed data EG may include a set of exponential Golomb encoding operations performed for each differential encoded sample of the plurality of differential encoded samples.

The set of exponential Golomb encoding operations may include division of the corresponding differential encoded sample of the plurality of differential encoded samples by 2 to the power of the order value. The set of exponential Golomb encoding operations may further include encoding of a quotient of the division. The encoding of the quotient may include addition of 1 to the quotient, conversion of the obtained result to binary, counting of a number of bits (for example, M) in the binary, and appending of (M-1) leading zeros to the obtained binary. The set of exponential Golomb encoding operations may further include concatenation of k bit binary value of a remainder of the division to the encoded quotient.

In an example, the corresponding differential encoded sample may be 13 and k=2. In such an example, 13 may be divided by 2², thus the quotient may be 3. Further, the encoding of the quotient may include addition of 1 to the quotient and conversion of the obtained result to binary that corresponds to 100. As a result, M=3, thus 2 leading zeros are appended to '100' that results in the encoded quotient being 00100. Further, k bit binary value of the remainder that corresponds to 2 bit binary value of 1 which is 01 is concatenated to 00100. As a result, the exponential Golomb encoding of 13 may generate 0010001 as a corresponding exponential Golomb encoded compressed sample with the length value of 7 bits. Remaining exponential Golomb encoded compressed samples of the plurality of exponential Golomb encoded compressed samples may be generated in the above-described manner.

The exponential Golomb encoding circuit 204 may be further configured to output the exponential Golomb encoded compressed data EG and the plurality of length values LV. In other words, the exponential Golomb encoding circuit 204 may output the plurality of exponential Golomb encoded compressed samples and the plurality of length values LV associated therewith. The data rate of the exponential Golomb encoded compressed data EG may be less than the data rate of the differential encoded data DE based on the second compression.

### Variable length code buffer circuit 206:

The variable length code buffer circuit 206 may be coupled to the exponential Golomb encoding circuit 204 and the physical interface 106. The variable length code buffer circuit 206 may include suitable circuitry (e.g., one or more data interfaces, one or more processors, one or more logic circuits, one or more data storage structures, or a combination thereof) that may be configured to perform one or more operations. For example, the variable length code buffer circuit 206 may be configured to receive, from the exponential Golomb encoding circuit 204, the exponential Golomb encoded compressed data EG and the plurality of length values LV. Further, the variable length code buffer circuit 206 may be configured to aggregate the exponential Golomb encoded compressed data EG based on an aggregation value and the plurality of length values LV.

The aggregation of the exponential Golomb encoded compressed data EG may correspond to aggregation of the plurality of exponential Golomb encoded compressed samples based on the aggregation value and the plurality of length values LV. As each exponential Golomb encoded compressed sample of the plurality of exponential Golomb encoded compressed samples may have a unique length value, the variable length code buffer circuit 206 may aggregate the plurality of exponential Golomb encoded compressed samples based on the aggregation value. In an example, the aggregation value may be 16 bits. In such an example, the compressed data CD may be aligned to 16 bits based on the aggregation. Furthermore, the variable length code buffer circuit 206 may be configured to output the compressed data CD based on the aggregation. The compressed data CD may be received by the physical interface 106. Further, the compressed data CD may be transmitted by the physical interface 106.

The data decompression circuit 118 may include an exponential Golomb decoding circuit 208 and a DPCM decoding circuit 210.

### Exponential Golomb decoding circuit 208:

The exponential Golomb decoding circuit 208 may be coupled to the physical interface 106 and the DPCM decoding circuit 210. The exponential Golomb decoding circuit 208 may include suitable circuitry (e.g., one or more data interfaces, one or more processors, one or more logic circuits, one or more data storage structures, or a combination thereof) that may be configured to perform one or more operations. For example, the exponential Golomb decoding circuit 208 may be configured to receive the compressed data CD from the physical interface 106. Further, the exponential Golomb decoding circuit 208 may be configured to perform the first decompression on the compressed data CD. Furthermore, the exponential Golomb decoding circuit 208 may be configured to generate the differential encoded data DE based on the first decompression.

The exponential Golomb decoding circuit 208 may be associated with the order value 'k'. Further, the order value of the exponential Golomb decoding circuit 208 may be configurable. The performance of the first decompression and the generation of the differential encoded data DE may be based on the order value. Additionally, the performance of the first decompression and the generation of the differential encoded data DE may include a set of exponential Golomb decoding operations performed for the generation of each differential encoded sample of the plurality of differential encoded samples.

The set of exponential Golomb decoding operations may include the determination of a quotient 'q', the determination of a remainder 'r', and the reconstruction of a corresponding differential encoded sample based on the quotient and the remainder. The determination of the quotient may include counting a number of leading zeros 'L' in the compressed data CD, reading the next 'L+1' bits in the compressed data CD, converting the L+1 bits to a decimal value 'd', and computing the quotient 'q' as 'd-1'. Further, the determination of the remainder 'r' may include reading the next 'k' bits after the 'L+1' bits in the compressed data CD and converting the next 'k' bits to decimal to obtain the remainder 'r'. The reconstruction of the corresponding differential encoded sample (for example, 'n') may include multiplication of the quotient to 2 to the power of k and addition of the remainder to the product of the multiplication (i.e., n=(q×2^{k})+r). A next differential encoded sample of the plurality of differential encoded samples may be generated in the above-described manner by beginning the determination of the quotient using a set of bits that occur after the next 'k' bits in the compressed data CD. Similarly, the remaining differential encoded samples of the plurality of differential encoded samples may be generated.

The exponential Golomb decoding circuit 208 may be further configured to output the differential encoded data DE.

### DPCM decoding circuit 210:

The DPCM decoding circuit 210 may be coupled to the exponential Golomb decoding circuit 208 and RADAR processing circuitry 120. The DPCM decoding circuit 210 may include suitable circuitry (e.g., one or more data interfaces, one or more processors, one or more logic circuits, one or more data storage structures, or a combination thereof) that may be configured to perform one or more operations. For example, the DPCM decoding circuit 210 may be configured to receive the differential encoded data DE from the exponential Golomb decoding circuit 208. Further, the DPCM decoding circuit 210 may be configured to perform the second decompression on the differential encoded data DE. Furthermore, the DPCM decoding circuit 210 may be configured to generate the decimated digital data DD based on the second decompression. The decimated digital data DD may correspond to the plurality of ADC samples.

The DPCM decoding circuit 210 may be associated with the set of DPCM coefficients. Further, the set of DPCM coefficients may be configurable. The performance of the second decompression and the generation of the decimated digital data DD may be based on the set of DPCM coefficients. Additionally, the performance of the second decompression and the generation of the decimated digital data DD may include a set of differential decoding operations performed for the generation of each ADC sample of the plurality ADC samples.

The set of DPCM decoding operations for the generation of a first ADC sample of the plurality of ADC samples may include computation of a prediction value using an initial value and the set of DPCM coefficients, and addition of the prediction value to a first differential sample of the plurality of differential samples. The set of DPCM decoding operations for the generation of a second ADC sample of the plurality of ADC samples may include computation of a prediction value using the initial value, the first ADC sample, and the set of DPCM coefficients, and addition of the prediction value to a second differential sample of the plurality of differential samples. The remaining ADC samples of the plurality of the ADC samples may be generated in the above-described manner. The DPCM decoding circuit 210 may be further configured to output the decimated digital data DD. The decimated digital data DD corresponds to a decompressed version of the compressed data CD.

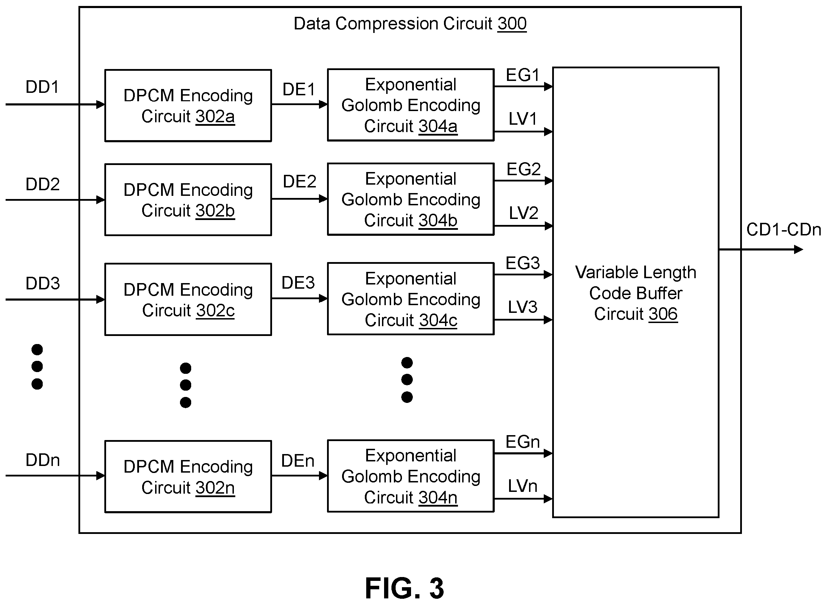

FIG. 3 illustrates a data compression circuit 300 in accordance with another embodiment of the present disclosure.

The data compression circuit 300 may include suitable circuitry that may be configured to perform one or more operations. For example, the data compression circuit 300 may be configured to facilitate compression of multi-channel data. The data compression circuit 300 may be associated with a plurality of channels. Further, the data compression circuit 300 may be configured to receive decimated digital data associated with each channel of the plurality of channels. Furthermore, the data compression circuit 300 may be configured to perform the first compression on each received decimated digital data based on the DPCM encoding to generate corresponding differential encoded data. Additionally, the data compression circuit 300 may be configured to perform the second compression on each differential encoded data based on the exponential Golomb encoding to generate corresponding exponential Golomb encoded compressed data.

The data compression circuit 300 may include a plurality of DPCM encoding circuits 302a-302n, a plurality of exponential Golomb encoding circuits 304a-304n, and a variable length code buffer circuit 306.

### Plurality of DPCM encoding circuits 302a-302n:

The plurality of DPCM encoding circuits 302a-302n may be coupled to the plurality of exponential Golomb encoding circuits 304a-304n, respectively. Each DPCM encoding circuit of the plurality of DPCM encoding circuits 302a-302n may be structurally and functionally similar to the DPCM encoding circuit 202. Thus, each DPCM encoding circuit may be configured to receive the corresponding decimated digital data, perform the first compression on the received decimated digital data, and generate the corresponding differential encoded data based on the first compression. Further, each DPCM encoding circuit may be configured to output the corresponding differential encoded data. The decimated digital data is denoted as "DD1-DDn" and the differential encoded data is denoted as "DE1-DEn", in FIG. 3.

### Plurality of exponential Golomb encoding circuits 304a-304n:

The plurality of exponential Golomb encoding circuits 304a-304n may be coupled to the variable length code buffer circuit 306. Each exponential Golomb encoding circuit of the plurality of exponential Golomb encoding circuits 304a-304n may be structurally and functionally similar to the exponential Golomb encoding circuit 204. Thus, each exponential Golomb encoding circuit may be configured to receive the differential encoded data from the corresponding DPCM encoding circuit of the plurality of DPCM encoding circuits 302a-302n. Further, each exponential Golomb encoding circuit may be configured to perform the second compression on the received differential encoded data and generate the corresponding exponential Golomb encoded compressed data based on the second compression. Furthermore, each exponential Golomb encoding circuit may be configured to output a plurality of length values associated with the corresponding exponential Golomb encoded compressed data. The exponential Golomb encoded compressed data is denoted as "EG1-EGn" and the plurality of length values is denoted as "LV1-LVn", in FIG. 3.

### Variable length code buffer circuit 306:

The variable length code buffer circuit 306 may be structurally and functionally similar to the variable length code buffer circuit 306. Thus, the variable length code buffer circuit 306 may be configured to receive, from each exponential Golomb encoding circuit, the corresponding exponential Golomb encoded compressed data and the plurality of length values. Further, the variable length code buffer circuit 306 may be configured to aggregate the corresponding exponential Golomb encoded compressed data based on an aggregation value and the corresponding plurality of length values. Based on the aggregation of the exponential Golomb encoded compressed data associated with the plurality of exponential Golomb encoding circuits 304a-304n, the variable length code buffer circuit 306 may be configured to output compressed data. The compressed data may correspond to a compressed version of the decimated digital data associated with the plurality of channels. The compressed data is denoted as "CD1-CDn" in FIG. 3.

Although not shown, the compressed data may be decompressed by a decompression circuit that includes a plurality of exponential Golomb decoding circuits and a plurality of DPCM decoding circuits. Each exponential Golomb decoding circuit of the plurality of exponential Golomb decoding circuits may be structurally and functionally similar to exponential Golomb decoding circuit 208. Further, each DPCM decoding circuit of the plurality of DPCM decoding circuits may be structurally and functionally similar to the DPCM decoding circuit 210.

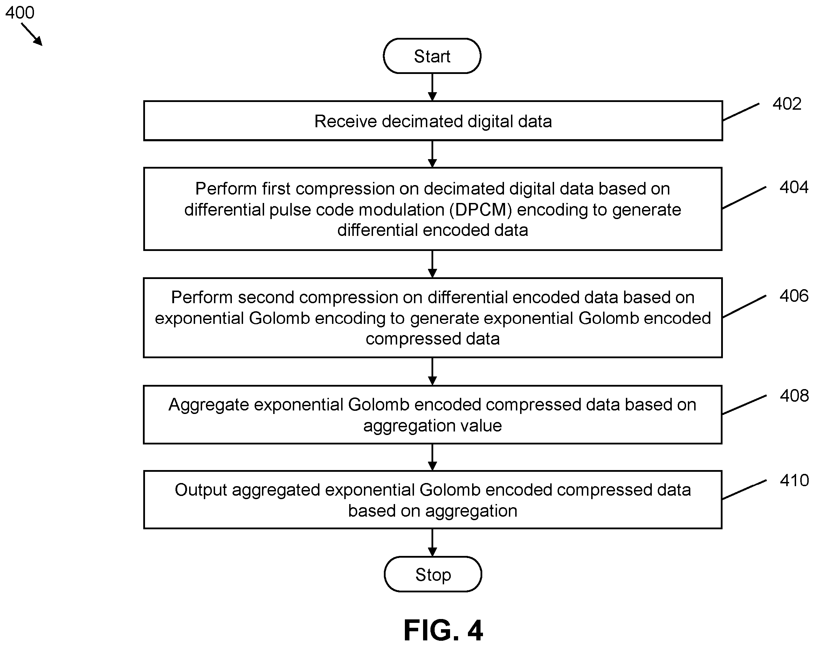

FIG. 4 represents a flowchart 400 that illustrates a data compression method in accordance with an embodiment of the present disclosure. The data compression method may be executed by the data compression circuit 114.

At step 402, the decimated digital data DD may be received by the data compression circuit 114. The decimated digital data DD may be received from the decimation circuit 112. The decimated digital data DD may correspond to the plurality of ADC samples. At step 404, the first compression may be performed on the decimated digital data DD based on the DPCM encoding to generate the differential encoded data DE, by the data compression circuit 114. The differential encoded data DE may correspond to a first compressed version of the decimated digital data DD.

At step 406, the second compression may be performed on the differential encoded data DE based on the exponential Golomb encoding to generate the exponential Golomb encoded compressed data EG, by the data compression circuit 114. The exponential Golomb encoded compressed data EG may correspond to a second compressed version of the decimated digital data DD. At step 408, the exponential Golomb encoded compressed data EG may be aggregated by the data compression circuit 114 based on the aggregation value. At step 410, the compressed data CD may be output by the data compression circuit 114 based on the aggregation.

The present disclosure discloses the system 100 that facilitates data compression and data decompression. The data compression circuit 114 performs the first compression based on the DPCM encoding that may result in reducing the standard deviation of the decimated digital data DD. Additionally, the data rate of the differential encoded data DE may be lesser than the data rate of the decimated digital data DD due to the first compression. Further, the data compression circuit 114 performs the second compression on the differential encoded data DE based on the exponential Golomb encoding that may result in the exploitation of sparsity in the differential encoded data DE. As a result, the data rate of the exponential Golomb encoded compressed data EG may be lesser than the data rate of the differential encoded data DE, thereby resulting in a higher compression ratio in comparison to conventional data compression techniques. As a result, the bandwidth requirement of the physical interface 106 for transmission of the compressed data CD is reduced in comparison to conventional bandwidth requirements. Also, the storage capacity required for storing the compressed data CD may be lower in comparison to conventional storage requirements. Additionally, the performance of the first compression and the second compression may correspond to lossless compression. As a result, no data is lost during the first compression and the second compression. Further, the first decompression and the second decompression may correspond to lossless decompression. As a result, the decimated digital data DD may be reconstructed by the data decompression circuit 118 without any data loss.

In an embodiment of the present disclosure, an electronic circuit is disclosed. The electronic circuit may comprise a data compression circuit that may be configured to receive digital data and perform first compression on the digital data based on differential pulse code modulation (DPCM) encoding to generate differential encoded data. The data compression circuit may be further configured to perform a second compression on the differential encoded data based on exponential Golomb encoding to generate exponential Golomb encoded compressed data.

In some embodiments, the data compression circuit may comprise a DPCM encoding circuit and an exponential Golomb encoding circuit coupled to the DPCM encoding circuit. The DPCM encoding circuit may be configured to receive the digital data and perform the first compression on the digital data. The DPCM encoding circuit may be further configured to generate the differential encoded data based on the first compression. The exponential Golomb encoding circuit may be configured to receive the differential encoded data from the DPCM encoding circuit and perform the second compression on the differential encoded data. The exponential Golomb encoding circuit may be further configured to generate the exponential Golomb encoded compressed data based on the second compression.

In some embodiments, the DPCM encoding circuit may be associated with a set of DPCM coefficients, and the set of DPCM coefficients may be configurable.

In some embodiments, the exponential Golomb encoding circuit may be associated with an order value, and the order value of the exponential Golomb encoding circuit may be configurable.

In some embodiments, the exponential Golomb encoding circuit may be further configured to output a plurality of length values associated with the exponential Golomb encoded compressed data.

In some embodiments, the data compression circuit may further comprise a variable length code buffer circuit coupled to the exponential Golomb encoding circuit. The variable length code buffer circuit may be configured to receive, from the exponential Golomb encoding circuit, the exponential Golomb encoded compressed data and the plurality of length values. The variable length code buffer circuit may be further configured to aggregate the exponential Golomb encoded compressed data based on an aggregation value and the plurality of length values. Further, a variable length code buffer circuit may be configured to output aggregated exponential Golomb encoded compressed data based on the aggregation.

In some embodiments, the exponential Golomb encoded compressed data may correspond to a compressed version of the digital data.

In some embodiments, the digital data may correspond to a plurality of analog-to-digital conversion (ADC) samples.

In some embodiments, the differential encoded data may correspond to a representation of the plurality of ADC samples where each ADC sample is encoded as a difference between a corresponding ADC sample and a predicted ADC sample. The predicted ADC sample may be processed based on one or more prior ADC samples of the plurality of ADC samples.

In some embodiments, the exponential Golomb encoded compressed data may correspond to a representation of the differential encoded data as a variable-length bitstring composed of a unary prefix and a binary suffix.

In some embodiments, the digital data may correspond to decimated digital data.

In certain embodiments of the present disclosure, an electronic circuit is disclosed. The electronic circuit may comprise a data decompression circuit that may be configured to receive compressed data and perform first decompression on the compressed data based on exponential Golomb decoding to generate differential encoded data. The data decompression circuit may be further configured to perform a second decompression on the differential encoded data based on differential pulse code modulation (DPCM) decoding to generate digital data.

In some embodiments, the data decompression circuit may comprise an exponential Golomb decoding circuit that may be configured to receive the compressed data and perform the first decompression on the compressed data. The exponential Golomb decoding circuit may be further configured to generate the differential encoded data based on the first decompression.

In some embodiments, the exponential Golomb decoding circuit may be associated with an order value, and the order value of the exponential Golomb decoding circuit may be configurable.

In some embodiments, the data decompression circuit may further comprise a DPCM decoding circuit coupled to the exponential Golomb decoding circuit. The DPCM decoding circuit may be configured to receive the differential encoded data from the exponential Golomb decoding circuit and perform the second decompression on the differential encoded data. The DPCM decoding circuit may be further configured to generate the digital data based on the second decompression.

In some embodiments, the DPCM decoding circuit may be associated with a set of DPCM coefficients, and the set of DPCM coefficients may be configurable.

In some embodiments, the digital data may correspond to a plurality of analog-to-digital conversion (ADC) samples.

In some embodiments, the digital data may correspond to a decompressed version of the compressed data.

In some embodiments, the compressed data may correspond to exponential Golomb encoded compressed data.

In certain additional embodiments, a data compression method is disclosed. The data compression method may include receiving, by a data compression circuit, digital data and performing, by the data compression circuit, first compression on the digital data based on differential pulse code modulation (DPCM) encoding for generating differential encoded data. The data compression method may further include performing, by the data compression circuit, a second compression on the differential encoded data based on exponential Golomb encoding for generating exponential Golomb encoded compressed data.

In numerous additional embodiments, a system is disclosed. The system may include a first electronic circuit and a second electronic circuit coupled to the first electronic circuit. The first electronic circuit may be configured to perform a first compression on digital data based on differential pulse code modulation (DPCM) encoding to generate differential encoded data. The first electronic circuit may be further configured to perform a second compression on the differential encoded data based on exponential Golomb encoding to generate exponential Golomb encoded compressed data. The second electronic circuit may be configured to receive the exponential Golomb encoded compressed data and perform a first decompression on the exponential Golomb encoded compressed data based on exponential Golomb decoding to generate the differential encoded data. The second electronic circuit may be further configured to perform a second decompression on the differential encoded data based on differential pulse code modulation (DPCM) decoding to generate the digital data.

While various embodiments of the present disclosure have been illustrated and described, it will be clear that the present disclosure is not limited to these embodiments only. Numerous modifications, changes, variations, substitutions, and equivalents will be apparent to those skilled in the art, without departing from the scope of the present disclosure, as described in the claims. Further, unless stated otherwise, terms such as "first" and "second" are used to arbitrarily distinguish between the elements such terms describe. Thus, these terms are not necessarily intended to indicate temporal or other prioritization of such elements. The term "coupled" may refer to at least one of direct or indirect coupling that may not necessarily be by way of mechanical or any physical means. Further, a system or method that "comprises", "has", or "includes" one or more elements possesses those one or more elements but is not limited to possessing only those one or more elements.

## Claims

1. An electronic circuit, comprising:
a data compression circuit configured to:
receive digital data;
perform a first compression on the digital data based on differential pulse code modulation, DPCM, encoding to generate differential encoded data; and
perform a second compression on the differential encoded data based on exponential Golomb encoding to generate exponential Golomb encoded compressed data.

2. The electronic circuit of claim 1, wherein the data compression circuit comprises:
a DPCM encoding circuit configured to:
receive the digital data;
perform the first compression on the digital data; and
generate the differential encoded data based on the first compression;
and
an exponential Golomb encoding circuit coupled to the DPCM encoding circuit, wherein the exponential Golomb encoding circuit is configured to:
receive the differential encoded data from the DPCM encoding circuit;
perform the second compression on the differential encoded data; and
generate the exponential Golomb encoded compressed data based on the second compression.

3. The electronic circuit of claim 2, wherein the DPCM encoding circuit is associated with a set of DPCM coefficients, and wherein the set of DPCM coefficients is configurable.

4. The electronic circuit of claim 2 or 3, wherein the exponential Golomb encoding circuit is associated with an order value, and wherein the order value of the exponential Golomb encoding circuit is configurable.

5. The electronic circuit of any of claims 2 to 4, wherein the exponential Golomb encoding circuit is further configured to output a plurality of length values associated with the exponential Golomb encoded compressed data.

6. The electronic circuit of claim 5, wherein the data compression circuit further comprises a variable length code buffer circuit coupled to the exponential Golomb encoding circuit, wherein the variable length code buffer circuit is configured to:
receive, from the exponential Golomb encoding circuit, the exponential Golomb encoded compressed data and the plurality of length values;
aggregate the exponential Golomb encoded compressed data based on an aggregation value and the plurality of length values; and
output aggregated exponential Golomb encoded compressed data based on the aggregation.

7. The electronic circuit of any preceding claim, wherein the digital data corresponds to a plurality of analog-to-digital conversion, ADC, samples.

8. The electronic circuit of claim 7, wherein the differential encoded data corresponds to a representation of the plurality of ADC samples where each ADC sample is encoded as a difference between a corresponding ADC sample and a predicted ADC sample, and wherein the predicted ADC sample is processed based on one or more prior ADC samples of the plurality of ADC samples.

9. The electronic circuit of claim 8, wherein the exponential Golomb encoded compressed data corresponds to a representation of the differential encoded data as a variable-length bitstring composed of a unary prefix and a binary suffix.

10. An electronic circuit, comprising:
a data decompression circuit configured to:
receive compressed data;
perform a first decompression on the compressed data based on exponential Golomb decoding to generate differential encoded data; and
perform a second decompression on the differential encoded data based on differential pulse code modulation (DPCM) decoding to generate digital data.

11. The electronic circuit of claim 10, wherein the data decompression circuit comprises:
an exponential Golomb decoding circuit, wherein the exponential Golomb decoding circuit is configured to:
receive the compressed data;
perform the first decompression on the compressed data; and
generate the differential encoded data based on the first decompression.

12. The electronic circuit of claim 11, wherein the exponential Golomb decoding circuit is associated with an order value, and wherein the order value of the exponential Golomb decoding circuit is configurable.

13. The electronic circuit of claim 11 or 12, wherein the data decompression circuit further comprises:
a DPCM decoding circuit coupled to the exponential Golomb decoding circuit, wherein the DPCM decoding circuit is configured to:
receive the differential encoded data from the exponential Golomb decoding circuit;
perform the second decompression on the differential encoded data; and
generate the digital data based on the second decompression.
